# EUROPEAN PATENT APPLICATION

(11) **EP 4 752 583 A1**
(43) Date of publication of application: **03.06.2026**
(21) Application number: 24215907.7
(22) Date of filing: 27.11.2024
(51) Int. Cl.: G01R 33/34

(54) **FLEXIBLE RADIO FREQUENCY ANTENNA FOR A MAGNETIC RESONANCE EXAMINATION SYSTEM**

(71) Applicant: LEIDEL u. KRACHT SCHAUMSTOFF-TECHNIK GMBH, 50735 Köln (DE)
(72) Inventor: DUENSING, George Randall, 22417 Hamburg (DE); FINDEKLEE, Christian, 22846 Norderstedt (DE); SMITH, Ramon, 51429 Bergisch Gladbach (DE)
(74) Representative: Richardt Patentanwälte PartG mbB

(57) **Abstract**

A method of manufacturing of an RF-antenna's electrical circuit for a magnetic resonance examination system, comprising the steps of
- receiving a specification of the RF-antenna's electrical circuit's division into a number of circuit-segments,
- providing an electrically conductive sheet,
- excise the circuit-segments from the electrically conductive sheet, the excised circuited-segments being separated and
- assemble the excised circuit-segments according to provide the electrical circuit.

A method of manufacturing of an RF-antenna's electrical circuit as claimed in Claim 1, wherein prior to the excision of the circuit segments, the circuit-segments are delimited individually in the electrically conductive sheet's area of electrically conductive material.]

## Description

### FIELD OF THE INVENTION

The invention pertains to a radio frequency (RF)-antenna for a magnetic resonance examination system. In particular, the invention pertains to a flexible RF-antenna. The invention also pertains to a method of manufacturing of an RF-antenna.

### BACKGROUND

The RF-antenna may be employed for transmission of RF-fields for manipulation of nuclear spins in the object to be examined (e.g. a patient to be examined) and/or for acquiring of magnetic resonance signals from the object to be examined. In practice, the RF-antenna may be formed with RF-coils to transmit an RF-field into the magnetic resonance examination system's examination zone and/or to pick-up magnetic flux associated with the magnetic resonance signals.

A flexible RF-antenna is known from the European patent application EP4405697A1**.** This known RF-antenna comprises MR coil sheets with electrically conductive MR coil elements or MR coil element portions disposed in electrically insulating sheets. The MR coil sheets have edges with connecting mechanisms configured to connect the MR coil sheets to construct an MR coil array.

### SUMMARY OF THE INVENTION

An object of the invention is to provide a method of manufacturing of an RF-antenna which is simpler and less expensive. It is also an object of the invention to provide a method of manufacturing of an RF-antenna that is more ecologically sustainable.

According to the invention, this object is achieved by the method of manufacturing of an RF-antenna's electrical circuit of Claim 1.

Another object of the invention is to provide an RF-antenna which is simpler and less expensive to manufacture.

According to aspects of the method of the invention, the RF-antenna's electrical circuit is divided into a number of circuit-segments. This division may be generated separate from the manufacturing of the RF-antenna. This division may be derived from the electrical circuit lay-out designed for the electrical circuit for the RF-antenna to be manufactured. Then the method of manufacturing receives the already generated division. This is achieved by providing the generated division as input into the method, or the method may access the generated division which may be stored remotely, e.g. in a data network such as storage in the cloud. A specification of this division may be provided to be received as input of the method of the invention. This specification may describe the sizes and shapes of the circuit-segments as well as the geometric pattern according to which the circuit segments are arranged on the electrically conductive sheet. Alternatively, the division into circuit-segments may be integrated with the manufacturing. The circuit-segments are separated from an electrically conductive sheet having a layer of electrically conductive material. In a simple approach the circuit-segments can then be directly excised according to the specification of the sizes, shaped and geometric pattern from the electrically conductive sheet, e.g. by (laser) cutting, punching-through or sawing between neighbouring circuit-segments to separate the individual circuit-segments from the electrically conductive sheet. The excised separate circuit-segments are subsequently assembled so as to form the electrical circuit of the RF antenna, i.e. arranged according to the electrical circuit lay-out for the RF-antenna.

In another implementation the circuit-segments may be delimited e.g. by drawing or outlining them on the electrically conductive sheet and then excised from the electrically conductive sheet.

In another implementation, the electrically conductive material is locally removed e.g. by machining, milling or etching the material away, in a pattern such that the circuit-segments are delimited from the remaining electrically conductive material with some separation between them. This may be achieved by removing the electrically conductive material along the outlines of the individual circuit segments. These circuit-segments can then be excised from the remaining sheet, e.g. by (laser) cutting or sawing between neighbouring circuit-segments defined in the remaining sheet to isolate the individual circuit-segments from the electrically conductive sheet. These isolated separated circuit-segments are subsequently assembled according to the electrical circuit, so that they configure the electrical circuit having the electrical functionality associated with the electrical circuit. Optionally, the configured electrical circuit formed by the circuit-segments arranged in their proper positions relative to each other may be covered by an overlay to protect the electrically conductive material from oxidation. Because the electrical circuit is divided into a number of circuit-segments, the circuit-segments can be defined in the electrically conductive sheet at a high area density, e.g. in that at least 60-70% of the surface area is taken up by defined circuit-segments. The geometric pattern with which the circuit-segments are defined in/on the electrically conductive sheet may be optimised with respect to the relative area of the sheet from which the circuit segments are formed. The optimisation may also take into account ease of the excision by simple navigation between the outline circuit-segments. The optimisation algorithm may be implemented in software and may also make use of Al-techniques. Hence, a relatively limited amount of electrically conductive material is removed e.g. from the outlines of the circuit-segments or not used viz. material between circuit-segments delimited on the electrically conductive sheet, so that more efficient use is made from the starting material. Notably, when electrically conductive material is removed by machining or milling, it is easy to collect the removed material, usually in the form of dust or flakes. This form of removed material is further easy to recycle to new electrically conductive sheets. Further, the electrically conductive sheet with the circuit-segments removed is still in the form of a sheet, albeit with holes where the circuit-segments have been excised. This remaining sheet may easily be recycled to a new electrically conductive sheet that is starting material for the method of the invention. Alternatively, the remaining area may be used directly e.g. by making segments for different coils (or other applications) at the same time from the same sheet.

During removal of the electrically conductive material local capacitances and/or local inductances may be monitored for tuning of the electrical circuit's frequency resonances. In this way, capacitances and inductances may be manufactured *in situ* more accurately. This approach may also be employed for the manufacturing of transmission-lines and RF-traps which require characteristic impedances or resonance frequencies in a narrow range.

Further, alternatively, the circuit-segments may be delimited by indicating their outlines and excising them from the electrically conductive sheet along their respective outlines. The outlines may be drawn on the electrically conductive sheet or represented in the control/driving software of a cutting-device that is driven to cut-out the circuit-segments along their outlines.

The electrically conductive sheet with the circuit-segments individually defined may considered to be an intermediate technical result that can be employed as input to a subsequent step of excising the circuit-segments from the electrically conductive sheet. Alternatively, the defining of the circuit-segments in the electrically conductive sheet may be integrated with the excision of the circuit segments form the electrically conductive sheet. E.g. for specially customised designs a customised set of segments can be provided, which a customer can place of have placed on a substrate to achieve an optimized placement for making an RF-coil (array) according to the customised design.

The electrically conductive sheet can be formed as a laminate of pcb-material or another electrically insulating material that provides mechanical support and covered on one or both sides with the electrically conducting material. Good results are achieved with pcb-sheets with Cu deposited on one-side or both sides. The electrical material may be formed with metals such as Al, Cu, Ag, Au, or conducting oxides such as indium-tin oxide. Moreover, oxide semiconductors such as zinc oxide, cadmium oxide and indium oxide can be highly doped to render them electrically conducting films. Further, a variety of materials may be used such as plane copper, copper with tin or silver coatings, copper on Polyimide or PEN with or without adhesive between and also could be double sided copper. Notably metal foils can be employed, in particular commercial grade copper foil. The coverlay may be formed as a polyimide sheet with b-stage epoxy that allows fluidity at temperatures in the range of 150-200C under pressure.

The electrically conductive sheet may be self-supporting, and the circuit-segments excised from it may be deposited on an electrically insulating substrate. Alternatively, the excised circuit-segments may be mounted on an electrically insulating frame. In another version, the electrically conductive sheet may be formed as a laminate of the electrically conductive material deposited on a substrate layer that provides for mechanical stability.

It is found that the aspects of the method are well suited for the manufacturing of RF-antenna circuit of a large area (e.g. as compared to commercially available pcb-based circuit for consumer applications) and volumes of hundreds to a few thousand products per year. Some implementations of the method of the invention achieve to manufacture an RF-antenna which can be larger than sizes that are limited by standard etching and electroplating tanks' dimensions.

According to another aspect of the invention, for the locally removing of the electrically conductive material so as to generate the circuit-segments, the electrically conductive sheet is held in place on a vacuum table with a perforation pattern. The electrically conductive sheet is placed with the geometric configuration of the outlines of the circuit-segments relative to the perforation pattern such that the locations of the outlines of the circuit-segments are at least to a large extent disjoint from the locations of the perforations. Ideally, no perforations should be at outlines of the circuit-segments. In practice good results with a high yield are achieved when less than 5%, even less than 2% or less than 1% of the perforations (unintentionally) coincide with an outline of one of the circuit-segments. In order to easily cut-out the defined circuits segments form the electrically conductive sheet, a thin sheet, foil or laminate is employed. In order to accurately remove the electrically conductive material by milling or machining, the electrically conductive sheet needs to be very flat and very well held in position. This may be achieved by placing the electrically conductive sheet over the vacuum table while some of the electrically conductive material is removed. The work surface of the vacuum table on which an object (here the electrically conductive sheet) is held in position is provided with a pattern of perforations through which underpressure is generated below the object so that the object is fixed by ambient air pressure. In order to avoid deformation of the electrically conductive material during its fixation on the work surface by the underpressure of the vacuum table the perforations through which the underpressure is generated and the circuit-segments defined in the electrically conductive sheet are relatively to be positioned such that the perforations correspond with centre regions of the circuit-segments, i.e. away from the circuit-segments' edges. To this end a customised perforation pattern of the vacuum table may be employed. The perforation pattern and the geometric arrangement of the circuit-segments on the electrically conductive sheet are configured such that the locations of the perforations re largely disjoint from the location of the outlines of the circuit-segments. In particular, the perforation pattern may be aligned along the respective main axes of the respective circuit-segments. In this way deformation is avoided at the edges of the ultimate excised circuit-segments. Any dimples that may occur in the inner region of the electrically conductive material of the circuit-segments hardly affect the electrical properties of the circuit-segments. Moreover, in subsequent process steps, like heating and pressing, to finalise the electrical circuit and the RF-antenna , the deformations due to dimples may be cured e.g. due to restoration of the crystal structure of metal in the sheet.

In a further aspect of the invention a replaceable hole pattern is configured in dependence of the circuit-segment configuration in the electrically conductive sheet. The replaceable hole pattern may be placed over the perforation pattern of work surface of the vacuum table. The pattern of holes of the replaceable hole pattern enables to position the electrically conductive sheet such that the hole pattern's holes are located to a large extent disjointly from the outlines of the circuit-segments. That is, when the replaceable hole pattern is used, the hole pattern assumes the function of the perforations of the work surface of the vacuum table to distribute the underpressure over the electrically conductive sheet such that deformations near the edges of the defined circuit-segments are avoided. That is the replaceable hole pattern acts as a customised tool to distribute the openings over the work surface of the vacuum table in accordance with the configuration of the circuit-segments defined in the electrically conductive sheet. The replaceable hole pattern is configured according to the configuration of the circuit-segments. For example, the hole pattern may be arranged along centre lines or centre curves of the outlined circuit-segments. In this way to a very large extent the holes of the replaceable hole pattern are located disjointly from the outlines of the circuit-segments. In a practical implementation the performance of the tabletop of the vacuum table is formed as a regular finely spaced grid of perforation with a small cross-section. The replaceable pattern may have a smaller number of holes of larger cross section and configured in dependence of the arrangement of circuit-segments delimited on the electrically conductive sheet. The replaceable pattern is simply placed over the work surface and may be replaced by a different hole pattern when a different configuration of the circuit-segments in to be held in place on the work surface.

In a further aspect of the invention, local capacitances and/or inductances of the circuit-segments are being monitored during the excising of the electrically conductive material. Notably, when the electrically conductive material is removed by machining or milling, monitoring of the local capacitances and/or inductances is simple to perform. According to this aspect of the invention, the circuit-segments' electromagnetic resonances can be accurately tuned according to the requirements of the ultimate electrical circuit formed by the assembled circuit-segments. This provides an improved yield of the manufacturing process.

In another aspect of the invention, the circuit-segments defined in the electrically conductive sheet are closely positioned with respect to each other such that they fill at least 60-70% or more of the surface area of the electrically conductive sheet. Accordingly, at most a minority of 30-40% of the electrically conductive material is removed or not used for the circuit-segments, so that most of the electrically conductive material ends up in the excised circuit-segments, with which the electrical circuit is configured.

Another object of the invention is to provide an RF-antenna that has a simple configuration of the electrical components, and which is simple and inexpensive to manufacture.

According to embodiments of an RF-antenna of the invention, electrical circuit is formed with one or more layers comprising one or more electrically conductive loops formed from an electrically conductive sheet, wherein each of the respective individual electrically conductive loops reside in a single one of the layers. Note that a single one of the layers may include several loops, but none of the loops is distributed among more than one layer. Hence, there is no need to form crossings of electrically conducting traces to opposite sides of the layer(s) which would require conductive vias that are difficult to manufacture in a reliable manner, i.e., with a high yield. Further, such vias would come with resistive losses as the electrical current is forced through electrically deposited copper rings at these conducting vias. According to the invention, there is no need for vias as resistive losses are lower.

In an embodiment the lamination of one or more layers has one layer in which most of the electrically conductive loops reside. At some locations, where electrically conductive parts overlap, they reside in different layers. This lamination may be bent e.g. in order to shape the RF-antenna to the anatomy of the patient to be examined or to properly shape an RF-antenna fixedly mounted in the magnetic resonance examination system. The layer containing most of the electrical loops and other electrically conductive parts are arranged in the neutral plane associated with the bending radius with the same amount of material on each side of the layer containing most of the electrical loops. In this way the mechanical stress on the electrically conducting material is minimised. Accordingly, the electrical loops that are mostly in the single layer in the neutral plane are less affected to material stress than electrical conductive parts in a conventional pcb-arrangement where the electrically conductive parts are at one or both sides of an insulating substrate.

According to embodiments of the invention, an RF-antenna is provided that contain at most two to four layers of electrical circuit components. Such a low number of layers suffices to accommodate all, or most functionalities that are to be enabled by the RF-antenna when employed in a magnetic resonance examination system, notably a clinical type of magnetic resonance imager. Moreover, such an RF-antenna with only a low number of layers of electrical components may be manufactured by the method of manufacturing as disclosed herein.

In an embodiment of the RF-antenna of the invention, the electrical circuitry is covered in a protective cover. This provides protection of the sensitive electrical circuitry from potentially damaging external influences. E.g. ingress of moisture is counteracted effectively. Further the foam cover provides for a comfortable feeling when the RF-antenna is placed on or around on or against a body part of a patient to be examined. As the patient to be examined is more comfortable, the patient will generally be moving less so that image quality is improved in that the level of motion artefacts is lower of the magnetic resonance image formed from the magnetic resonance signal acquired by the RF-antenna. The protective cover may be a foam cover or a poly-urethane sleeve.

In various embodiments of the RF-antenna of the invention the electrical circuit includes one or more acquisition loops to capture magnetic flux associated with magnetic resonance signals and optionally e.g. strip-line transmission lines to transfer the magnetic resonance signals and or flat resonant trap circuits inductively and or capacitively coupled to the strip-line transmission lines. Other configurations for the transmission lines may be employed like e.g. coplanar, potentially with shielding layer. The safety level of the flat resonant traps may be improved by providing a temperature sensor adjacent to the trap to monitor temperature. For example, in the event the temperature sensor detects that the temperature of the trap exceeds a pre-set safety-value, the RF-antenna may be shut down, e.g. to prevent damage to the RF-antenna or injury such as burns to the patient to be examined.

In further embodiments the RF-antenna may be formed as a flexible RF-antenna. This allows to place the RF-antenna snugly on or around body parts, such as shoulder, elbow, knee or ankle of the patient to be examined. This achieves the RF-antenna to be placed close to the tissue from which the magnetic resonance signals are generated. This improves the signal-to-noise ratio of the RF-antenna when employed in a magnetic resonance examination system. Alternatively, fixed specially adapted curved shapes of the RF-antenna may be provided.

The RF-antenna may be flexible in that the material of the RF-antenna, notably the substrate or frame which holds the electrical circuit formed with the circuit elements and the coverlay, and optionally also the circuit-segments themselves are deformable to allow the RF-antenna to be flexed around or over a part of the patient's anatomy to be examined. Alternatively, the flexibility of the RF-antenna may be achieved by providing one or more folds between electrical circuit parts and in the substrate or the frame and optionally in the coverlay along which the RF-antenna may be folded to fit around or on the patient's anatomy to be examined. This flexibility is achieved by an RF-antenna of the invention that allows for deformation with a radius of curvature of about 4-5cm or more without causing irreversible deformations, notably of the electrical circuit, the substrate or frame.

Also, an embodiment of the RF- of the invention is the application as a transmit/receive body coil fixedly mounted in the magnetic resonance examination system comprising one or more RF-antenna assemblies, e.g. forming a quadrature body coil (QBC) for the magnetic resonance examination system. The QBC may be formed from several curved sections which together constitute a cylindrical shape that fits within the magnet bore of the magnetic resonance examination system. Circuit-segments can be mounted on the curved sections assembled so as to configure the QBC electrical circuit. These circuit-segments may be manufactured by delimiting the circuit-segments individually in the electrically conductive sheet's remaining areas of electrically conductive material and excising the separate circuit-segments from the electrically conductive sheet and assemble the excised circuit-segments according to the electrical circuit onto the cylindrically curved sections.

In another embodiment the RF- of the invention is formed as an RF-coil array that is mounted to a patient carrier at its side opposite to the magnetic resonance examination system's examination zone. Typically, the RF-coil array be mounted a configured as a posterior RF-coil array for spine-imaging.

Another aspect of the invention pertains to radio frequency (RF) cable or line trap. The RF-trap of the invention is formed by a laminated flat radio frequency line trap structure comprising
- a flat top spiral arm conductor,
- a flat bottom spiral arm conductor and
- respective sections of the flat top spiral arm conductor and the flat bottom spiral arm conductor are capacitively coupled forming an AC-loop being resonant at a predetermined resonant frequency.

This aspect of the invention may also pertain to a trapped transmission line comprising the laminated flat RF-line trap structure disposed over a flat transmission line structure. The terms top and bottom merely serve to indicate that the spiral arms are offset transversely to the planes of the spiral arms. In a more advanced embodiment, the trapped transmission line may be provided with a periodic succession of laminated flat radio frequency line trap structures between which the top and bottom layer arrangements are longitudinally (i.e. along the long axis of the flat transmission line) alternated.

The spiral arm conductors may be provided with extensions for fine tuning of the capacitive couplings. This is achieved by making small alterations to the geometric shape of the extensions, e.g. by removing some of the electrically conductive material of the extensions. This is easily achieved by making small local indentations in the extensions. The capacitive coupling can be accurately established by locally removing material form the extensions. The removal of material may be done by milling, machining or directly etching of small holes. Small patches of conductive material may be intentionally disposed in the loop areas form by the spiral arms. These small patches may be (partly) removed for resonant tuning of the RF-line trap structure.

The capacitive coupling between the sections of top and bottom spiral arms may be formed by simple lumped capacitors or by way of distributed capacitive couplings. Further, the capacitive couplings may be influenced by providing of local meanders in the spiral arms.

The laminated flat RF-line trap structure may be manufactured by the method of manufacturing of any one of Claims 1 to 9. However, the laminated flat RF-line trap structure may also be manufactured by conventional manufacturing methods, such as known methods to manufacture printed circuit boards.

The flat laminated design of the laminated flat RF-line trap structure has small dimensions in the directions transverse to the planes of the spiral arms and accordingly is not bulky. Notably the flat laminated design does not take up significant building height transverse to the transmission lines. Moreover, the laminated flat RF-line trap structure is well compatible with flexible RF-coil arrays. Further, the laminated flat RF-line trap structure is well compatible with tape shaped transmission lines which further reduces building height transversely to the long axis of the transmission line.

### BRIEF DESCRIPTION OF THE DRAWINGS

Further detailed embodiments and implementations of the inventions are elaborated on with respect to the drawings, wherein
Figures 1 and 2 represent flow charts of respective implementations of the method of manufacturing of an RF-antenna's electrical circuit;
Figure 3 shows an example of an arrangement of delimiting the circuit-segments individually in the electrically conductive sheet's areas of electrically conductive material;
Figure 4 shows an example of a part, viz. a simple capacitively tune loop, of the electrical circuit of the RF-antenna;
Figure 6 shows a top view onto the work surface of the vacuum table with the replaceable hole pattern in place and onto which some of the circuit-segments' outlines shown in the electrically conductive sheet over the replaceable hole pattern;
Figure 7 shows a schematic side elevation of the vacuum-table set up for carrying out an implementation of the manufacturing method of the invention;
Figure 8 shows a diagrammatic representation of a realistic schematic of the electrical circuit of an RF- as made according to the method of the invention and
Figure 9 shows a diagrammatic representation of an RF-line trap according to the invention.

### DETAILED DESCRIPTION

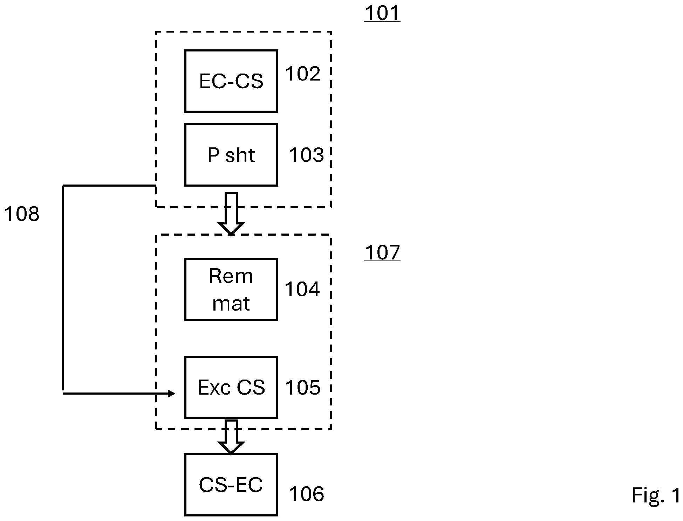

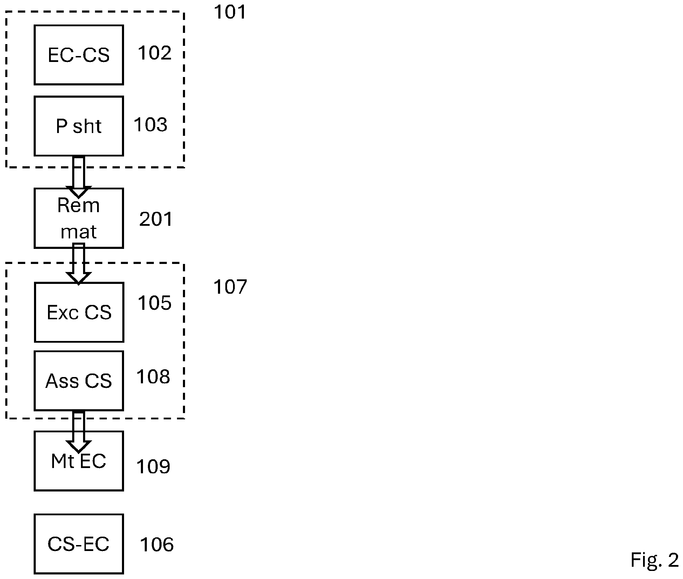

Figures 1 and 2 represent flow charts of respective implementations of the method of manufacturing of an RF-antenna's electrical circuit. The manufacturing starts with the provision of the division 102 of the electrical circuit-lay out into circuit-segments and providing 103 the electrically conductive sheet. These initial steps of providing the electrically conductive sheet and the division into circuit-segments may be combined in an integrated phase 101. At this stage, the electrical-circuit as well as the division into circuit-segments may be represented in software or as a suitable (digital datasets). These datasets are input to the physical manufacturing of the circuit-segments as hardware components in step 107. File formats suitable the datasets for the representation of the pattern on the sheet are e.g. STP files, Gerbers or DWG formats can be used. Further, MasterCAM is a particular software to control the system. Further AI and other smart tools to help convert a proposed electrical circuit's lay-out into constituent segments and optimized compression onto several standard sheet options. To produce the circuit-segments they may be excised directly as indicated by the by-pass 108 from the electrically conductive sheet as separate circuit-segments.

To delimit the circuit segments on the electrically conductive sheet, electrically conductive material may be removed 104 along the outlines on the circuit-segments on the electrically conducting sheet. Subsequently the delimited circuit-segments are excised 105 from the sheet so as to isolate the separate circuit-segments from the electrically conductive sheet.

The removal of the electrically conducive material to generate the outlines of the circuit-segments may be done in a step 104 preceding the excision 105 of the circuit segments 105. However, the definition of the outlines of the circuit segments on the electrically conducting sheet and excising the circuit-segments from the electrically conductive sheet may be combined or alternated in a combined manufacturing phase 107. Finally, the excised circuit-segments are assembled 106 in the configuration of the electrical circuit- of the RF-antenna to form the physical electrical circuit. In the step 106 the circuit-segments may be placed on a substrate or mounted on a frame to hold the assembled circuit-segments to form to the RF-antenna's electrical circuit.

In the version of the implementations of the method of manufacturing of an RF-antenna's electrical circuit shown in Fig. 2, a removal step 201 to remove the remaining material that is not part of the outlined circuit segments is carried-out. The removed material may be recycled for use as input material for the manufacture of further electrical circuits. Then, optionally in a combined phase 107 the circuit segments are excised and then assembled according to the specified electrical circuit and then mounted in a mounting-step 109 to form the electrical circuit which may be finished in step 106.

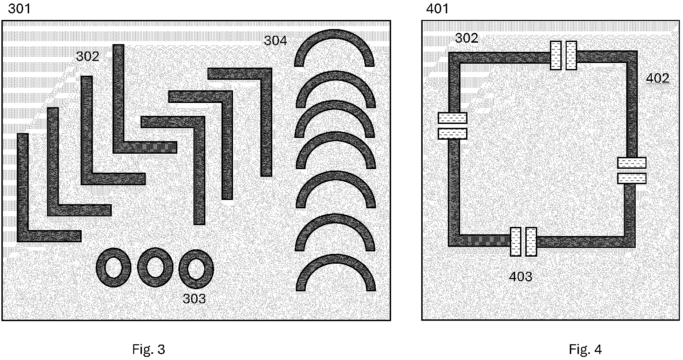

Figure 3 shows an example of an arrangement of delimiting the circuit-segments individually in the electrically conductive sheet's areas of electrically conductive material. Onto or into the electrically conductive sheet 301, there are outlined (e.g. by local removal of electrically conductive material along the outlines of the circuit-segments). There is a relatively small number of different types of circuit segments 302, 303 and 304, for each of which several circuit segments are outlined.

Figure 4 shows an example of a part, viz. a simple capacitively tuned loop, of the electrical circuit of the RF-antenna, made-up from circuit-segments outlined in Fig. 3. These circuit segments 302, 303, 304 are excised from the electrically conductive sheet 301 and placed on a substrate 401 or frame 401. In the example a simple capacitive tuned coil-loop is made for capturing magnetic flux associated with a magnetic resonance signal. The capacitive tuning may be achieved by way of lumped capacitors 403 in series with the circuit segments 302 forming the coil-loop. Alternatively, the capacitances 403 may be formed as distributed capacitances by way of electrically conducting strips that are disposed at the opposite side of the substrate 401 forming the distributed capacitances by the electrically conducting strips, the circuit-segments 302 with a dielectric layer in or of the substrate between them.

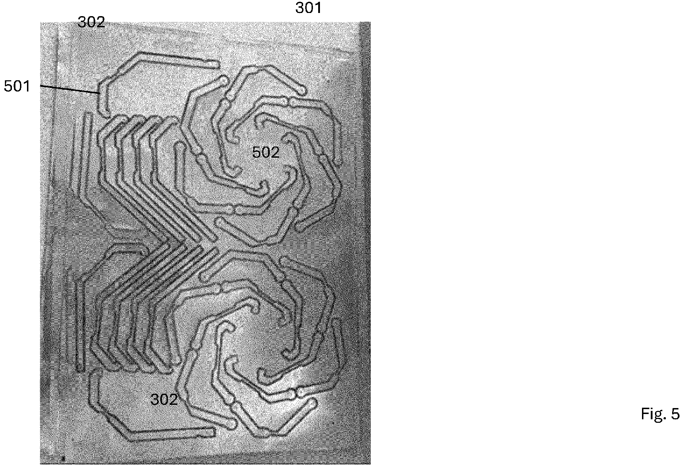

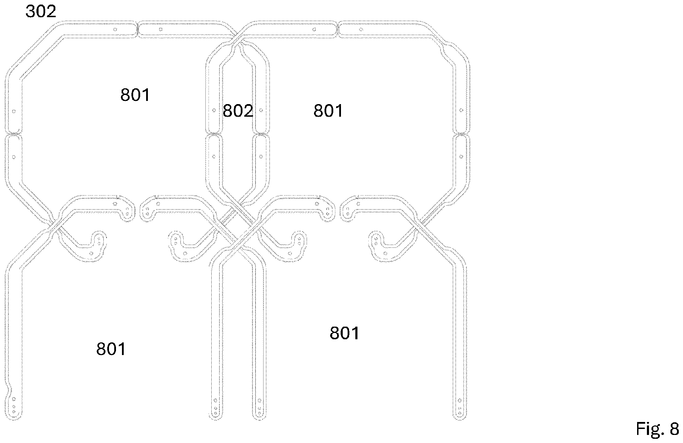

Figure 5 shows an example of the electrically conductive sheet's in/on which circuit-segments are delimited individually in areas of electrically conductive material. In the electrically conductive sheet 301 the circuit-segments 302 are outlined 501 in that a locally electrically conducive material is removed corresponding to the size and shape of the circuit-segments 302. An area 502 of remaining electrically conductive material is indicated that may be re-used for making another product. It is apparent from Fig. 5 that the circuit-segments are outlined in the electrically conducting sheet 301 at a high area density, notably an area density that is significantly higher than the area density of the circuit-segments 302 as assembled according to the electrical circuit layout is shown e.g. in Fig. 4 and Fig.8.

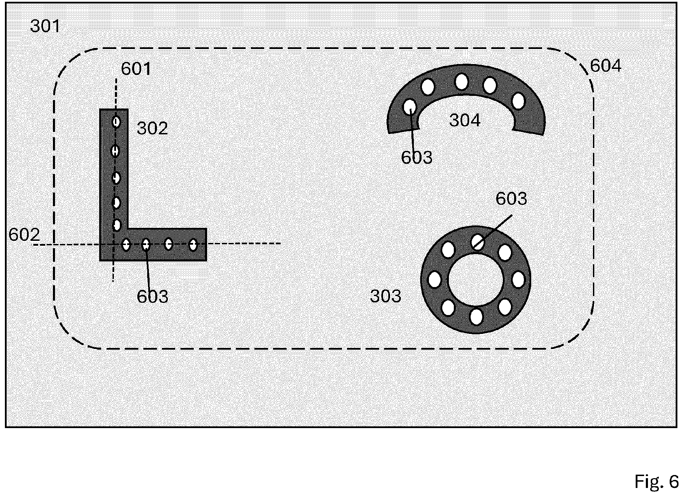

Figure 6 shows a top view onto the work surface of the vacuum table with the replaceable hole pattern 604 in place and onto which some of the circuit-segments' outlines shown in the electrically conductive sheet over the replaceable hole pattern. The electrically conductive sheet 301 is placed over the work surface 702 with perforations of a vacuum table 701 on which the electrically conductive sheet is held in position by underpressure generated by drawing air into the perforations. The replaceable hole pattern 604 is placed over the work surface of the vacuum table and has a hole pattern of holes 603 in corresponding with the shapes of the outlined circuit segments 302, 303 and 304. More in particular, the holes of the replaceable hole pattern are aligned with principal axes 601, 602 of the circuit-segment 302. For the curved circuit-segments 303 and 304, the holes 603 are aligned with the curved shapes of the circuit-segments such that the holes are located along the centre curves of the curved circuit-segments. The customised replaceable hole pattern 604 ensures that the holes 603 are located away from the edges of the outline circuit-segments, so that local forces due to the underpressure at the holes 603 may not or at most hardly deform the edges of the circuit-segment while the electrically conductive sheet 301 is held firmly in place. Any deformations that may occur along the centre lines or curves of the circuit segments will disappear or be reduced e.g. by annealing due to local re-crystallisation of the metal forming the circuit-segments during post-processing of the circuit-segments 302, 303, 304, e.g. after they have been excised form the metallic sheet in assembled according to specified electrical circuit.

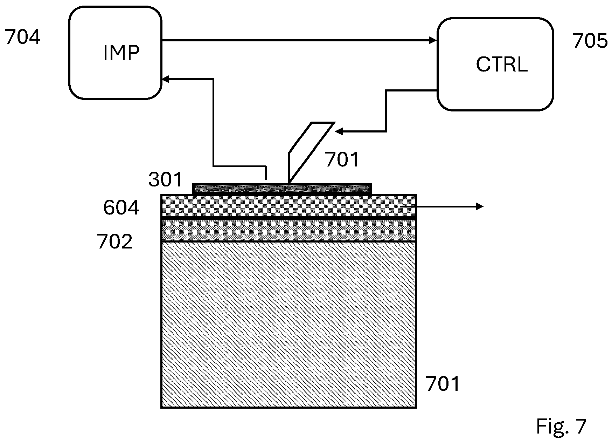

Figure 7 shows a schematic side elevation of the vacuum-table set up for carrying out an implementation of the manufacturing method of the invention. The vacuum table 701 is provided with a work surface 702 onto which a workpiece, e.g. the electrically conductive sheet is held firmly in place by underpressure generated by drawing air though the work-area's perforations. In a more sophisticated version, the replaceable hole pattern 604 is disposed over the work surface 702. The replaceable hole pattern is a customised hole pattern 604 corresponding to the configuration of the circuit-segments 302, 303 and 304 on the electrically conductive sheet 301, in that the holes of the customised hole pattern 604 correspond with the centre lines or positions of the circuit-segments, and are not at or near edges of the outlines circuit-segments. To outline the circuit segments on the electrically conductive sheet 301 a machining-tool (e.g. a chisel or cutter) 701 is driven along the destined outlines of the circuit-segments 302, 303, 304 on the electrically conductive sheet. A controller 705 controls the machining tool that has access to the datasets for the representation of the pattern of the circuit-segments lines on the electrically conductive 301 sheet. The vacuum table 701 may be provided with a local impedance monitor 704 that has electronics to monitor local electrical (complex) impedances (inductances, capacitances, complex permittivity) at the outlined circuit-segments 302. This enables to outline the circuit-segments on the electrically conductive sheet 301 so as to have the proper local impedances for correct RF-resonant frequencies and bandwidths as specified ultimately for the electrical circuit of the RF-antenna to be manufactured. To monitor the local impedances, at least a sector of the work surface of the vacuum table should be electrically insulating (e.g. made of ceramic or plastic-type material), or the entire work surface may be electrically insulating so that the circuit-segments is electrically floating (i.e. not electrically grounded to the vacuum table).

Figure 8 shows a diagrammatic representation of a realistic schematic of the electrical circuit of an RF-antenna as made according to the method of the invention. More in particular, Figure 8 shows (parts) of overlapping coil loops 801 of an RF-coil array. The coil loops are assembled for circuit-segments 302 and partly the coil loops are overlapping 802 so as to inductively decouple adjacent coil loops 801 by way of magnetic flux cancellation in the overlapping area 802.

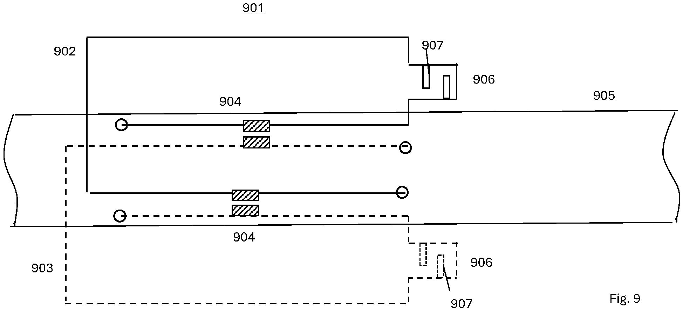

Figure 9 shows a diagrammatic representation of an RF-line trap structure according to a further aspect of the invention.

The RF-line trap structure 901 is formed as laminated flat RF-line trap structure over a flat (e.g. tape like) transmission line 905. The laminated flat RF-line trap structure comprises a flat top spiral arm 902 and a flat bottom spiral arm 903. In this example the spiral arms have slightly more than one rotation. Other amounts of rotations for the spiral arms may be employed as well. The terms top and bottom here merely serve to indicate that the spiral arms are offset transversely to the parallel planes of the spiral arms. Sections of the respective top and bottom spiral arms 902 and 903 are capacitively coupled 904 so that the RF-line trap structure has a resonance at a predetermined resonance frequency. The capacitive coupling may be formed by lumped capacitors of by a directed capacitive coupling between the respective segments of the spiral arms. In practice this resonant frequency is the Larmor frequency of a magnetic resonance examination system which generates the magnetic resonance signals from which a magnetic resonance image is reconstructed. The magnetic resonance signals are transmitted over the flat transmission line 905 and the RF-line trap suppresses the common mode and only allows the differential mode over the transmission line so that hazardous RF-resonances are avoided. The spiral arms of the laminated flat RF-line trap structure may have longitudinal extensions 906. These longitudinal extensions 906 bring about overlap-decoupling between the RF-line traps and are shaped in that the width of the extensions is less than the width of a half turn of the spiral arm to avoid or reduces capacitive coupling to the longitudinally adjacent RF -line trap. Further, indentations 907 may be made to the extensions. This may be carried-out during manufacture of the laminated flat RF-line trap structure or may be done alter when mounting the laminated flat RF-line strap structure e.g. in an RF-antenna, such as an RF-coil array for use in a magnetic resonance examination system.

## Claims

1. A method of manufacturing of an RF-antenna's electrical circuit for a magnetic resonance examination system, comprising the steps of
- receiving a specification of the RF-antenna's electrical circuit's division into a number of circuit-segments,
- providing an electrically conductive sheet,
- excise the circuit-segments from the electrically conductive sheet, the excised circuited-segments being separated and
- assemble the excised circuit-segments according to provide the electrical circuit.

2. A method of manufacturing of an RF-antenna's electrical circuit as claimed in Claim 1,
wherein prior to the excision of the circuit segments, the circuit-segments are delimited individually in the electrically conductive sheet's area of electrically conductive material.

3. A method of manufacturing of an RF-antenna as claimed in Claim 2 and wherein the delimitation of the circuit segments is done by locally removing electrically conductive material from the electrically conductive sheet.

4. The method of manufacturing of an RF-antenna as claimed in Claim 3, wherein.
- for the locally removing of the electrically conductive material, the electrically conductive sheet is held in placed on a vacuum table with a perforation pattern for the generation of the circuit-segments and
- the electrically conductive sheet is placed with the geometric configuration of the outlines of the circuit-segments relative to the perforation pattern such that the locations of the outlines of the circuit-segments are at least to a large extent disjoint from the locations of the perforations.

5. The method of manufacturing of an RF-antenna as claimed in Claim 1 or 2, wherein
- for the locally removing of the electrically conductive material, the electrically conductive sheet is held in place on a vacuum table with a perforation pattern for the generation of the circuit-segments and
- a replaceable hole pattern is configured in dependence of the circuit-segments' configuration in the electrically conductive sheet and the replaceable hole pattern is placed over the perforation pattern of the vacuum table.

6. The method of manufacturing of an RF-antenna as claimed in Claim 5 wherein the perforation pattern or the replaceable hole pattern is aligned with the central long axes of the circuit-segments to be generated.

7. The method of manufacturing of an RF-antenna as claimed in Claim 4, 5 or 6, wherein the vacuum table's perforation pattern or the replaceable hole pattern is provided in accordance with the electrical circuit of the RF-antenna assembly.

8. The method of manufacturing of an RF-antenna as claimed in any one of Claims 1 to 5, wherein the circuit-segments are defined so as to fill at least 60% or at least 70% of the surface area of the electrically conductive sheet.

9. The method of manufacturing of an RF-antenna as claim in Claim 1, 2 or 3, wherein during removal of the electrically conductive material local capacitances and/or local inductances are monitored for tuning of the electrical circuit's frequency resonances.

10. An RF-antenna with an electrical circuit, in particular with the RF-antenna's electrical circuit manufactured according to the method as defined in any one of Claims 1 to 9 and formed with one or more layers comprising one or more electrically conductive loops formed from an electrically conductive sheet, wherein respective individual electrically conductive loops each reside in a single one of the layers.

11. An RF-antenna as claimed in Claim 10, comprising 2 to 4 layers of electrical circuit components.

12. An RF-antenna as claimed in any one of Claims 10 or 11, wherein the RF-antenna's electrical circuit is covered in a protective cover.

13. An RF-antenna as claimed in any one of Claims 10 to 12, wherein the electrical circuit includes one or more acquisition loops to capture magnetic flux associated with magnetic resonance signals and optionally strip-line transmission lines to transfer the magnetic resonance signals and or flat resonant trap circuits inductively and or capacitively coupled to the strip-line transmission lines.

14. A magnetic resonance examination system comprising a transmit/receive body coil or fixedly mounted in the magnetic resonance examination system, or a posterior coil-array mounted relative to the magnetic resonance examination system examination zone and comprising one or more RF-antenna assemblies as claimed in any one of Claims 9 to 13.

15. A laminated flat radio frequency line trap structure comprising
- a flat top spiral arm conductor,
- a flat bottom spiral arm conductor and
- respective sections of the flat top spiral arm conductor and the flat bottom spiral arm conductor are capacitively coupled forming an AC-loop being resonant at a predetermined resonant frequency.
